(19) Europäisches Patentamt
European Patent Office
Office européen des brevets

(11) Numéro de publication: **0 100 251**
**A1**

(12) # DEMANDE DE BREVET EUROPEEN

(21) Numéro de dépôt: **83401260.1**

(22) Date de dépôt: **17.06.83**

(51) Int. Cl.³: **H 01 L 21/31**, H 01 L 21/316, H 01 L 21/302, H 01 L 29/62 // H01M8/12

(30) Priorité: **25.06.82 FR 8211215**

(43) Date de publication de la demande: **08.02.84 Bulletin 84/6**

(84) Etats contractants désignés: **DE GB IT NL**

(71) Demandeur: **THOMSON-CSF, 173, Boulevard Haussmann, F-75379 Paris Cedex 08 (FR)**

(72) Inventeur: **Croset, Michel, THOMSON-CSF SCPI 173, bld Haussmann, F-75379 Paris Cedex 08 (FR)**
Inventeur: **Mercandalli, Louis, THOMSON-CSF SCPI 173, bld Haussmann, F-75379 Paris Cedex 08 (FR)**

(74) Mandataire: **Lepercque, Jean et al, THOMSON-CSF SCPI 173, Bld Haussmann, F-75379 Paris Cedex 08 (FR)**

(54) **Procédé de réduction de composé en couche sur un substrat, et son application à la fabrication de structure semiconductrice à effet de champ.**

(57) Le procédé de l'invention comprend deux étapes: la première étape consiste à créer une couche d'électrolyte (3) à la surface de la couche à réduire (2), celle-ci étant une couche superficielle oxydée d'un substrat (1); et une seconde étape, pendant laquelle la couche (2) est réduite au travers de la couche d'électrolyte (3), conducteur ionique de l'éspèce ionisante. Selon une première variante, la seconde étape s'effectue par réduction thermique en atmosphère réductrice et selon une seconde variante, par exposition à un plasma réducteur.

Application notamment à la réduction d'oxydes natifs formés à la surface d'arseniure de gallium.

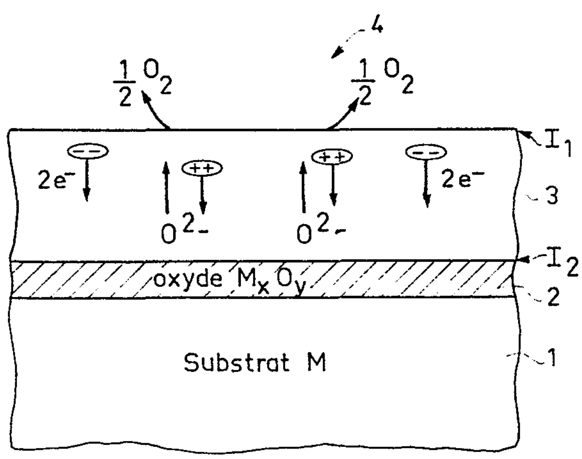


EP 0 100 251 A1

# PROCEDE DE REDUCTION DE COMPOSE EN COUCHE SUR UN SUBSTRAT ET SON APPLICATION A LA FABRICATION DE STRUCTURE SEMICONDUCTRICE A EFFET DE CHAMP

La présente invention concerne un procédé de réduction de composés formant au moins une couche superficielle sur un substrat, par exemple de la couche d'oxyde qui peut se former spontanément à la surface d'un substrat et peut s'appliquer notamment à la fabrication de structures semiconductrice à effet de champ de type "M.I.S".

Il est connu qu'une surface métallique ou semiconductrice clivée subissant une attaque chimique, ionique ou thermique se recouvre en un laps de temps très bref après le traitement, de l'ordre de quelques secondes, d'une mince couche d'oxyde ainsi qu'éventuellement d'autres espèces chimiques adsorbées. La couche ainsi formée a une épaisseur inférieure à une centaine d'Angströms.

Ce phénomène n'est pas sans inconvénients dans les techniques mis en oeuvre en micro-électronique ou sub-microélectronique et de façon plus générale dans toutes les techniques nécessitant la création de couches minces. Il s'ensuit en effet de profondes modifications des propriétés physico-chimiques, optiques et/ou électroniques de la surface de ces couches.

Un exemple particulièrement significatif, illustrant l'importance de ce phénomène, est celui des techniques récentes mettant en oeuvre des substrats en arseniure de gallium pour le développement de circuits intégrés performants, notamment comportant des éléments de types M.O.S., M.I.S. ou analogues. Ces dispositifs nécessitent la création de couches diélectriques, semiconductrices et/ou métalliques. Il existe pour ce type de circuits intégrés une relation entre le taux de couverture en oxygène de la surface du substrat et la courbure en surface du diagramme de bandes associé, ce qui a pour conséquence de fixer le niveau de FERMI, dans les régions superficielles, à peu près au milieu de la bande interdite. Les propriétés du matériau ne sont donc pas conservées dans leur intégrité jusqu'à la surface, ce qui a pour conséquence de nuire au bon fonctionnement de la plupart de dispositifs réalisés sur ces substrats.

Pour remédier aux inconvénients qui viennent d'être rappelés, une solution consisterait à nettoyer la surface du substrat, et à effectuer toutes les opérations successives de fabrication de ces dispositifs dans une enceinte dans laquelle règne une très basse pression connue sous la dénomination courante "ultra-vide" (pression inférieure à $10^{-11}$ Pa environ).

Outre les coûts très élevés et la complexité de mise en oeuvre associés à ce type de technique qui interdisent son utilisation comme procédé industriel opérationnel, il existe de toute façon un risque de contamination ultérieur de la surface lors du retour aux conditions atmosphériques normales.

Un besoin se fait donc sentir de pouvoir disposer d'un procédé de traitement n'exigeant pas la mise en oeuvre de techniques de vide poussé, et c'est le but que se fixe la présente invention.

L'invention a donc pour objet un procédé de réduction d'au moins une couche de composé oxydé par une espèce déterminée recouvrant tout ou partie de la surface d'un substrat ; caractérisé en ce qu'il comprend :

- une première étape pendant laquelle une couche d'un électrolyte solide conducteur électronique et conducteur ionique de ladite espèce déterminée est disposée de manière à recouvrir uniformément la surface du substrat ;

- et une seconde étape pendant laquelle ladite réduction est effectuée au travers de la couche d'électrolyte solide.

L'invention a également pour objet un procédé de fabrication d'une structure semiconductrice à effet de champ du type "M.I.S." comprenant les étapes du procédé de réduction.

L'invention sera mieux comprise et d'autres caractéristiques et avantages apparaîtront au moyen de la description qui suit et par référence aux figures qui l'accompagne et parmi celles-ci :

- la figure 1 illustre schématiquement les phénomènes physiques mis en jeu dans le cadre du procédé de l'invention.

- les figures 2 à 5 illustrent la fabrication d'une structure M.I.S. comprenant les étapes spécifiques au procédé de l'invention.

- la figure 6 est un schéma électrique équivalent à un dispositif comportant un substrat oxydé en surface et recouvert d'une couche d'électrolyte solide.

- la figure 7 est un diagramme illustrant le domaine d'exploitation du procédé dans le cadre d'un exemple particulier.

les figures 8 à 15 sont relatives à plusieurs variantes d'application du procédé selon l'invention.

Selon une caractéristique fondamentale du procédé de réduction selon l'invention, celui-ci comprend deux étapes principales : une étape préliminaire consistant à recouvrir la surface d'un substrat comportant une couche superficielle d'un composé à réduire par une couche de matériau diélectrique solide dont les caractéristiques seront précisées dans ce qui suit et une deuxième étape de réduction du composé au travers de la couche.

Les mécanismes fondamentaux mis en jeu vont tout d'abord être explicités par référence à la figure 1.

On suppose dans un premier temps, à titre d'illustration non-limitative du procédé que le composé à réduire est au moins un oxyde du matériau composant un substrat, celui-ci étant par exemple en matériau semiconducteur tel que l'arseniure de gallium.

Sur la figure 1 sont illustrés schématiquement un substrat 1 en matériau M recouvert d'une couche d'au moins un oxyde $M_x O_y$ de ce matériau, s'il en existe plusieurs possibles, et la couche de diélectrique 3, créée pendant la première étape et recouvrant la couche d'oxyde 2. Il existe donc deux interfaces : l'interface $I_1$ entre le milieu extérieur 4 et la couche de diélectrique 3 et l'interface $I_2$ entre cette couche et la couche d'oxyde 2.

On choisit un matériau diélectrique conducteur ionique exclusif de l'ion oxygène $O^{2-}$. La couche de diélectrique est destinée à subsister après le traitement réalisé pendant la seconde étape du procédé, soit comme membrane diélectrique, soit comme écran de passivation, interdisant toute recontamination de la surface du substrat 1.

Pour la réalisation de la seconde étape pendant laquelle la réduction effective est réalisée, on peut choisir, dans une première variante, une technique de traitement thermique sous atmosphère réductrice.

Pour ce faire, le substrat recouvert de sa couche d'oxyde et de la couche de matériau diélectrique selon le procédé de l'invention est placé dans une enceinte dans laquelle est introduit un mélange gazeux réducteur,

dont au moins un des éléments est un composé d'oxygène.

A titre d'exemple le mélange hydrogène/vapeur d'eau ($H_2/H_2O$) peut être utilisé dans le cadre de l'invention. D'autres mélanges sont également utilisables tel que le mélange monoxyde de carbone/dioxyde de carbone ($CO/CO_2$).

Dans le milieu extérieur 4 se produit la réaction réversible :

$H_2O \rightleftarrows H_2 + 1/2\, O_2$ (1)

On peut définir associées à une telle réaction, des pressions partielles et notamment la pression partielle d'oxygène $P_{O_2}$. Les pressions partielles des différentes espèces intervenant dans une réaction chimique effectuée entre deux gaz supposés parfaits et pour des transformations monothermes à pression extérieure constante peuvent être déterminée à partir des lois de la thermodynamique et sont liées entre elles par la variation de l'enthalpie libre standard $\Delta G_T^\circ$.

En effet à l'équilibre, température et pression partielle sont reliées à l'enthalpie libre standard par l'expression :

$RT \text{ Log } (P_{O_2}) = \Delta G_T^\circ$ (2)

Dans le cadre de l'exemple choisi, la relation suivante est vérifiée à l'équilibre :

$RT \text{ Log } (P_{O_2}) = \Delta G_T^\circ + RT \text{ Log } \left[ (P_{H_2O})^2 / (P_{H_2})^2 \right]$ (2a)

dans laquelle :

. R est la constante des gaz parfaits (8,314 J/[mole.°K])

. T est la température en degrés Kelvin

. ($P_{H_2O}$) est la pression partielle de la vapeur d'eau

. ($P_{H_2}$) est la pression partielle de l'hydrogène.

Connaissant la température T et les proportions respectives de monoxyde de carbone et de dioxyde de carbone, la pression partielle d'oxygène $P_{O_2}$ peut être déterminée en fonction de l'enthalpie libre.

Dans la couche d'oxyde se produit la réaction réversible du type :

$M_x O_y \rightleftarrows x\, M + (y/2)\, O_2$ (3)

x et y étant des nombres qui dépendent des nombres de valences respectifs

de l'espèce M consituant le substrat 1 et de l'oxygène (valence 2).

Par une méthode analogue, on peut déterminer la pression partielle d'oxygène $P'_{O_2}$ à l'interface $I_2$, pression qui dépend également de l'enthalpie libre standard, à la différence près que les concentrations des éléments solides n'interviennent plus. La pression partielle d'oxygène $P'_{O_2}$ vérifie la relation à l'équilibre :

$$RT \, Log \, (P'_{O_2}) = \Delta G^{o}_{T} \qquad (4)$$

Selon l'invention, le couple "pression partielle d'oxygène-température" doit être choisi de manière à obtenir simultanément une réduction de la couche d'oxyde et une oxydation de la couche d'électrolyte solide. Il existe donc un domaine possible pour ce couple qui sera défini de façon plus précise dans ce qui suit.

Ces conditions assurent des conduction électronique et ionique non négligeable au sein de l'électrolyte solide 3.

A titre d'exemple, l'électrolyte solide, comme il sera décrit ultérieurement peut être de la zircone stabilisée à la chaux ($Z_r O_2$ + Ca O). Une température de l'ordre de 500°C est suffisante pour satisfaire l'exigence précédemment énoncée.

Dans ces conditions, on créé à la surface, comme illustré sur la figure 1, des lacunes d'oxygène se traduisant par des charges positives ++ .

En effet, à l'interface $I_1$ se produit la réaction :

$$O^{2-} - 2 e^{-} \longrightarrow 1/2 \overset{\nearrow}{O_2} \qquad (5)$$

qui est une réaction d'oxydation de l'ion $O^{2-}$ avec simultanément libération d'électrons et d'oxygène. Si la stabilité de l'oxyde à réduire (couche 2) est plus faible que celle de l'électrolyte solide, à l'interface $I_2$ se produit la réaction :

$$(2\,y)\, e^{-} + M_x O_y \longrightarrow x\, M \searrow + y\, O^{2-} \qquad (6)$$

Les électrons résultent du transport par conduction électronique au sein de l'électrolyte solide des électrons libérés à l'interface $I_1$. De la même manière les ions oxygène libérés traversent, du fait de la conduction ionique, la couche d'électrolyte. Il y a donc un mouvement ambipolaire des espèces chargées au travers de la membrane d'électrolyte solide 3.

Si le temps de traitement est suffisamment long, il y a réduction

complète de la couche d'oxyde $M_x O_y$ et son remplacement par une couche de même nature que le substrat 1, si, comme il a été supposé, le matériau du substrat est identique au matériau oxydé.

Dans une étape ultérieure, l'ensemble est ramené dans les conditions normales de pression et de température et replacé à l'air libre. La couche d'électrolyte 3 joue alors le rôle d'écran de passivation interdisant toute recontamination ultérieure du substrat réduit, selon le but que s'est fixée l'invention.

Pour résumer, pour qu'il y ait réduction effective, il est nécessaire que les relations suivantes liant la température de l'enceinte T et la pression partielle en oxygène $P_{O_2}$, soient vérifiées simultanément :

$P_{RO} > P_{O_2} > P_{OE}$ (7)

et

$T_{RO} > T > T_{OE}$ (8) ;

les couples température-pression étant déterminés à partir de la formule (2), T devant en outre être inférieur à $T_{DO}$ ; dans lesquelles :

$P_{RO}$ : est la pression partielle maximale pour laquelle il y a réduction de la couche d'oxyde ;

$P_{OE}$ : est la pression partielle minimale pour laquelle il y a oxydation de la couche d'électrolyte ;

$T_{DO}$ : est la température à partir de laquelle il y a destruction de la couche d'oxyde, ou, s'il y a plusieurs oxydes, la température la plus basse occasionnant la destruction d'un au moins de ces oxydes ;

$T_{RO}$ : la température maximale pour laquelle il y a réduction de la couche d'oxydes ;

$T_{OE}$ : la température minimale pour laquelle il y a oxydation de la couche d'électrolyte.

Toutes ces relations définissent un domaine à l'intérieur duquel la réduction peut avoir lieu.

En outre, pour des raisons pratiques ce jeu de relation peut être complété par le jeu suivant :

$P_{O_2} > P_{PG}$ (9) ;

$P_{PG}$ étant la pression partielle minimale pouvant être obtenue à l'aide d'un système d'épuration de gaz donné ;

$P_{O_2} \lesssim 1$ atm (10) ;

puisque l'on désire travailler à pression atmosphérique (98 066,5 Pa)

$T > T_{TI}$ (11), $T_{TI}$ étant la température minimale pour laquelle le temps nécessaire à la réduction est égal à un temps que l'on se fixe à l'avance, temps qui doit être raisonnablement court pour que le procédé ait des applications pratiques.

Le procédé de l'invention va maintenant être décrit de façon plus détaillée dans le cadre de la fabrication de structures semiconductrices de type connu sous l'abréviation anglo-saxonne "M.I.S." (structure constituée d'un empilement Métal-Isolant-Semiconducteur) qui sont des dispositifs à effet de champ ; et plus particulièrement des structures "M.I.S." sur un substrat en arseniure de gallium.

Cette fabrication constitue en effet un exemple d'application dans laquelle la mise en oeuvre du procédé de l'invention est particulièrement avantageuse.

L'arseniure de gallium (GaAs) est source de difficultés spécifiques très aigües malgré l'intérêt qu'il présente par ailleurs pour la conception de circuits électroniques performants.

Un cas particulier d'une telle structure est la structure M.O.S. (de l'anglo-saxon : Métal-oxyde-semiconducteur) à oxyde natif.

Quelque soient les méthodes d'oxydation mises en oeuvre, la stoèchiométrie de l'oxyde est difficilement assurée, surtout dans les régions proches de l'interface. En fait, on assiste à l'interface entre la couche d'oxyde superficielle dont est muni ce type de dispositif et le substrat en arseniure de gallium à la formation spontanée d'une couche intermédiaire composite de faible épaisseur : typiquement 40 Angströms. Cette couche est formée d'arsenic et d'oxyde de gallium. Ceci est du au fait que l'oxyde d'arsenic est très instable. La réaction chimique s'effectue selon la relation :

$As_2 O_3 + 2\, GaAs \rightarrow Ga_2 O_3 + 4\, As$ (12)

Enfin, l'arsenic formé est très volatile. Ce phénomène a pour conséquence la formation de pièges donneurs et accepteurs dans la bande interdite qui se traduisent par des phénomènes d'hystérésis et de dispersions en fréquence et une dégradation correllative des performances des circuits électroniques réalisés à partir de ces structures.

On a fait appel dans l'art connu à d'autres diélectriques que l'oxyde natif pour minimiser les contraintes d'interfaces : nitrure de silicium ($Si_3 N_4$), alumine ($Al_2 O_3$), nitrure d'aluminium ($Al N$), dioxyde de silicium ($Si O_2$) ou nitrure de germanium ($Ge_3 N_4$) par exemple. La difficulté, comme précedemment, est d'éviter toute trace d'oxyde naturel. On est alors contraint à faire appel de nouveau aux techniques d'"ultra-vide".

Le procédé de l'invention permet d'éviter cette contrainte et en outre le diélectrique disposé sur le substrat pendant la première étape constitue un élément qui joue simultanément le rôle de couche de diélectrique proprement dit et d'encapsulant évitant l'exodiffusion de l'arsenic et la formation ultérieure de trace d'oxyde naissant.

Les figures 2 à 5 illustrent les principales étapes de la fabrication d'une structure "M.I.S." qui intègrent les étapes propres au procédé de l'invention.

Sur la figure 2, est représenté un substrat 1 en arseniure de gallium, préalablement préparé et nettoyé par toutes techniques appropriées qui sortent du cadre de l'invention et recouvert spontanément d'une couche superficielle 2 qui comprend de l'oxyde de gallium ($Ga_2 O_3$), de l'oxyde d'arsenic ($As_2 O_3$) et de l'arsenic selon le mécanisme qui a été rappelé.

Pendant la première étape, propre au procédé de l'invention, on dispose sur cet ensemble une couche de diélectrique 3, comme représenté sur la figure 3.

De façon préférentielle, on choisit comme matériau de base de la zircone stabilisée à la chaux ($Zr O_2 + Ca O$) dans des proportions atomiques respectives de 85% et 15%. Ce matériau est un bon conducteur ionique de l'oxygène à des températures supérieure ou égale à 500°C. Il constitue un bon encapsulant pour l'arseniure de gallium jusqu'à des températures de l'ordre de 850°C ce qui permet d'éviter l'exodiffusion de l'arsenic. Ce matériau a également un coefficient de dilatation proche de l'arseniure de gallium ce qui permet des dépôts sur des surfaces importantes de substrat sans risque de félures ou de décollement. Enfin les énergies endothermiques de formation de ce diélectrique étant élevées, il s'ensuit que ce matériau est stable même à température élevée et ne peut être réduit pendant la seconde étape du procédé en même temps que la couche d'oxyde 2. Il s'ensuit

également que l'interface entre la couche de diélectrique 3 et le substrat 1', une fois la couche d'oxyde réduit pendant la seconde étape du procédé, est une interface où les atomes As et Ga libérés lors de la réduction ont repris une position cristallographique en accord avec le réseau monocristallin sous-jacent.

La couche d'électrolyte 3 déposée a une épaisseur minimale de l'ordre de quelques centaines d'Angtröms de telle sorte qu'il soit assuré une structure sans trou et d'une épaisseur maximale de quelques milliers d'Angströms, limite fixée par l'adaptation des coefficients de dilatation linéaires entre la zircone et les couches sous-jacentes. De façon typique les épaisseurs sont situées dans la gamme 1000 à 2500 Angströms.

Le dépôt peut s'effectuer par toutes méthodes appropriées dans le domaine des couches minces, de façon préférentielle par la technique connue sous le nom de pulvérisation cathodique radio-fréquence.

De façon plus générale, le choix de la nature de l'électrolyte dépend des propriétés cristallographiques du substrat ou de la couche sous-jacente.

Le dispositif tel que représenté sur la figure 3 est placé ensuite, comme précédemment, dans une enceinte dans laquelle est établie une atmosphère réductrice contrôlée par exemple un mélange d'hydrogène ($H_2$) et de vapeur d'eau ($H_2O$), la proportion de la vapeur d'eau étant typiquement de l'ordre de 0,5 p.p.m. Dans le cas d'une production en petite série, il peut s'agir d'un tube de laboratoire. L'enceinte est portée à une température typiquement de l'ordre de 500°C.

Il existe à cette température, un large domaine de pressions partielles d'oxygène ($10^{-55}$ Pa $< P_{O_2} < 10^{-15}$ Pa) réducteur pour les oxydes d'arsenic et de gallium et oxydant pour la couche de zircone. Avec le mélange hydrogène-vapeur d'eau dans les proportions indiquées, la pression partielle d'oxygène $P_{O_2}$ est de l'ordre de $10^{-35}$ Pa, ce qui est situé dans la gamme précitée.

Dans le mélange gazeux les réactions chimiques satisfont la relation (1).

Dans la couche d'oxydes, la relation (3) se subdivise en deux relations élémentaires :

$4/3\ A_s + O_2 \rightleftarrows A_s(4/3)\ O_2$ (3a)

$4/3\ Ga + O_2 \rightleftarrows Ga\ (4/3)\ O_2$ (3b)

à partir desquelles la pression partielle d'oxygène $P'_{O_2}$ peut être définie, pression partielle qui vérifie la relation (4).

A l'interface $I_1$, la relation (5) est de nouveau vérifiée et, à l'interface $I_2$, la relation (6) est également subdivisée en deux relations élémentaires :

$12\ e^- + 2\ As_2O_3 \longrightarrow 4\ \underset{\rightarrow}{As} + 6\ O^{2-}$ (6a)

$12\ e^- + 2\ Ga_2O_3 \longrightarrow 4\ \underset{\rightarrow}{Ga} + 6\ O^{2-}$ (6b)

Pour rendre compte de la conductivité électronique d'une part et la conductivité ionique d'autre part, on peut définir expérimentalement un modèle électrique illustré par la figure 6 équivalent à la structure représentée sur la figure 3, sous la forme d'un dipôle constitué de trois impédances en série : l'impédance $Z_1$, comprenant en parallèle une résistance $R_1$ et une capacité $C_1$, qui représente l'impédance de l'interface $I_1$ ; l'impédance $Z_2$, comprenant une résistance $R_2$ et une capacité $C_2$ qui représente l'impédance de la couche de zircone dopée 3 ; et l'impédance $Z_3$ qui se réduit à une résistance $R_3$ qui représente l'impédance de la couche d'oxydes 2.

Les données expérimentales montrent que c'est essentiellement l'impédance $Z_1$ qui limite la conduction et que l'on peut assimiler l'ensemble sur un intervalle suffisamment long (régime statique), par unité de surface ($cm^2$), à une résistance équivalente qui est de l'ordre de $1,6\ 10^5\ \Omega\ cm^2$ compte-tenu des valeurs numériques sus-mentionnées et notamment de la température de traitement (500°C).

Pour une surface de substrat de $1 cm^2$, la couche d'oxyde(s) 2 ayant une épaisseur de 50 Angströms, il est nécessaire d'éliminer $2,2\ 10^6$ atomes d'oxygène, ce qui représente une charge de $7\ 10^{-3}\ C.cm^{-2}$, pour obtenir la réduction souhaitée. Dans ces conditions, l'étape de réduction doit durer 1050 s, soit 18mm environ. La structure à réduire doit donc être maintenue dans l'enceinte, dans les conditions de pression partielle d'oxygène et de température précitées, un temps au moins égal à 18mm et de façon plus général un temps calculé de façon analogue pour des valeurs numériques spécifiques autres que celles choisies pour exemple.

On obtient donc à la fin de la seconde étape du procédé selon l'invention la structure représentée à la figure 4, c'est à dire un substrat 1' débarrassé de sa couche d'oxyde(s) sur lequel est disposée une couche de zircone dopée 3.

La dernière étape pour obtenir une structure de type M.I.S. sort du cadre précis de l'invention et consiste à déposer selon une configuration prédéterminée des plages métalliques 5, en or par exemple. Cette étape ne diffère en rien de l'art connu, à l'exception que la couche de diélectrique nécessaire à une structure M.I.S. est formée désormais par la couche 3 de zircone dopée à la chaux, couche qui sert également, comme il a été rappelé, selon un aspect avantageux de l'invention, d'encapsulant.

Comme dans le cas général, dans le cadre de l'application qui vient d'être décrite, on peut définir un domaine utilisable pour opérer la réduction. Ce domaine est délimité par les données suivantes :

La température maximale est 800°C environ. Cette température correspond à la destruction de l'oxyde le moins stable en température : l'oxyde d'arsenic ($As_2 O_3$).

L'oxyde le plus difficile à réduire est l'oxyde de gallium : relation (6b)

L'oxydation de la zircone est réalisé conformément à la relation :

$$Zr + O_2 \rightarrow Zr\,O_2 \qquad (13)$$

Le calcul de l'enthalpie libre $\Delta G^{o}_{T}$ (relation 2) permet donc de définir des courbes limites portées sur le diagramme de la figure 7 : la courbe $C_1$ représentant la variation du logarithme de la pression partielle exprimée en atmosphère (1 atm = 98 066,5 Pa) en fonction de la température en °C, associée à la relation (6b) et la courbe $C_2$, associée à la relation (13).

Le domaine est borné supérieurement, de façon absolue en température, par la température de destruction de l'oxyde d'arsenic (# 800°C) et, de façon pratique, par la température minimale $T_{TI}$ pour laquelle le temps de traitement reste acceptable. Avec les données numériques précitées $T_{TI}$ = 250°C, ce qui correspond à un temps de traitement de 10h.

Sur le diagramme de la figure 7, le domaine est représenté en traits hachurés.

A titre d'exemples illustrés sur le diagramme de la figure 7, à température constante T = 500°C, la gamme des pressions partielles d'

oxygène possibles est celle déjà mentionnée ($10^{-55}$ Pa à $10^{-15}$ Pa) ; tandis que pour une pression constante correspondant à Log ($P_{O_2}$) = - 60, la température maximale limitant le domaine n'est pas la température $T_{RO}$ mais la température de destruction de l'oxyde d'arsenic, c'est à dire 800°C ($T_{RO}$ étant de l'ordre de 900°C).

Jusqu'à présent, il a été admis que la réduction, pendant la seconde étape du procédé s'effectuait, selon une première variante, par une technique de réduction sous atmosphère réductrice à pression atmosphérique.

Selon une seconde variante, la réduction peut s'effectuer par exposition à un plasma de gaz réducteur.

Pour ce faire, le dispositif à réduire comportant la couche d' électrolyte disposée pendant la première étape est placé dans une enceinte dans laquelle est créé un plasma, par exemple d'hydrogène. Ce plasma peut être soit un plasma dit "Radio fréquence" (R.F.), soit un plasma dit "continu".

Les appareillages de mise en oeuvre sont bien connus de l'homme de métier. Un exemple d'un tel appareil est décrit dans le brevet FR-B-2 394 173. Dans le premier cas la puissance électrique nécessaire pour l'alimentation de l'appareil est typiquement de 100W à une fréquence f = 60 MHz ; dans le second cas (continu) la puissance est typiquement 1W. La pression de l'enceinte est typiquement comprise entre $10^{-6}$ et $10^{-4}$ Pa.

On utilise de préférence un plasma échauffant le moins possible le dispositif à réduire de manière à conserver l'avantage spécifique de la réduction plasma, à savoir une réduction "à froid".

Le procédé de l'invention est susceptible d'autres applications.

De façon générale toute couche d'oxyde naturel ou d'oxyde constituée à partir du substrat peut être réduite quelque soit l'utilisation ultérieure du substrat.

Dans une autre variante, illustrée par les figures 8 et 9, le matériau oxydé peut être de nature différente de celui du substrat.

La figure 8 illustre un substrat 1 en un premier matériau M1, une, couche d'oxyde 2' à réduire en oxyde d'un second matériau M2 et une couche de diélectrique 3, par exemple de la zircone dopée à la chaux ($ZrO_2$ + $CaO$), couche déposée pendant la première étape du procédé.

A la suite de la seconde étape du procédé, la structure se présente

sous la forme illustrée par la figure 9 : un substrat 1 en matériau M1, une couche 2" en matériau M2 et la couche de diélectrique 3. Cette variante est particulièrement intéressante si le matériau M2 est un métal. On obtient alors une lame conductrice enterrée.

Dans une variante supplémentaire, illustrée par les figures 10 et 11, la couche d'oxyde peut être discontinue, c'est le cas par exemple d'un réseau d'interconnexions de conducteurs dans un circuit électronique intégré.

Comme illustré sur la figure 10, un substrat sur lequel ont été disposés un réseau de bandes conductrices d'interconnexions 2' constitué d'un métal ayant subit une oxydation naturelle dûe au phénomène précédemment rappelé, est recouvert d'une couche de diélectrique 3 sur toute sa surface pendant la première étape du procédé.

A la suite de la seconde étape, comme illustré par la figure 10, les bandes 2" sont réduites. Le substrat peut également être recouvert initialement d'une couche d'oxyde 20 (figure 10) qui va être réduite de la manière décrite précédemment et disparaitre également (figure 11).

Le substrat pour sa part peut être constitué d'un matériau semiconducteur comme il a été décrit jusqu'à présent, d'un métal massif à la surface duquel se forme un oxyde natif à réduire ou d'un oxyde formant diélectrique à réduire sur une profondeur déterminée, profondeur qui dépend essentiellement du temps de traitement de la seconde étape, tous autres paramètres étant fixés.

Le procédé de l'invention peut également être mis à profit dans les techniques mettant en oeuvre l'épitaxie en phase solide. Cette application va être décrite en référence aux figures 12 à 15.

La figure 12 représente un substrat 1 en un premier matériau semiconducteur, de l'arseniure de gallium par exemple dont la surface se recouvre spontanément d'une couche d'oxydes 2 conformément au mécanisme qui a été décrit précédemment.

Sur ce substrat, on dépose, comme représenté par la figure 13, une couche d'oxydes 6 d'un second matériau semiconducteur, par exemple d'oxydes de gallium et d'antimoine sur une épaisseur déterminée.

Conformément à la première étape du procédé de l'invention, l'ensemble comme représenté sur la figure 14, est recouvert d'une couche de

d'électrolyte solide 3, préférentiellement de la zircone stabilisée à la chaux ($Zr\ O_2 + Ca\ O$).

Ensuite, on procède à la seconde étape du procédé et la réduction simultanée des couches d'oxydes 2 et 6 est réalisée. On constate alors un réarrangement de type épitaxial des espèces gallium et antimoine pour former une couche d'antimoniure de gallium 6' (figure 15), issue de la couche d'oxydes 6 (figure 14) des mêmes espèces, sur le substrat 1' (figure 15) débarrassé de sa propre couche d'oxydes (fig.12 à 14 :2).

Le processus n'est pas limité à une seule couche. On peut donc obtenir par ce procédé un empilement épitaxial de couches de semiconducteurs de natures et d'épaisseurs différentes, éventuellement complété par des couches de réseaux d'interconnexions ou d'électrodes, obtenus de la manière décrite en relation avec les figures 10 et 11.

Enfin, de façon plus générale le procédé de l'invention peut s'appliquer à la réduction de composés autres que les oxydes. Des exemples de tels composés sont constitués par les nitrures. Un exemple est constitué par le nitrure de silicium. La réaction de réduction obéit à la relation :

$Si_3\ N_4 \rightarrow 3\ Si + 2\ N_2$ (14)

La réduction est obtenue à partir d'un transfert de l'ion $N^{3-}$ au travers d'un électrolyte solide qui est disposé sur le substrat pendant la première étape. Un exemple d'électrolyte est constitué par l'alumine β ammonium. Dans le cas de l'exemple sus-mentionné, ce substrat est en semiconducteur ou du moins supporte une couche de silicium. Tous autres types de substrats peuvent être également envisagé comme précédemment.

Les relations (7) et (8) peuvent être réécrites de façon plus générale :

$P_R > P_{esp} > P_O$ (7a)

$T_D > T_R > T > T_O$ (8a)

les indices R et O étant relatifs comme précédemment à la réduction du composé et à l'oxydation de l'électrolyte solide, l'indice D à la plus basse température de destructions des composés (s'il y en a plusieurs) et l'indice "esp" à l'espèce oxydante, l'azote dans l'exemple décrit.

Dans tout ce qui précède, les épaisseurs des substrats, bien que non limitées strictement, sont en général comprises dans les gammes suivantes :

. substrat semiconducteurs : 100 à 500 micromètres

. substrat métallique ou diélectrique : inférieure ou égale à 2mm.

Les couches d'oxydes natifs ont une épaisseur inférieure à 100 Angströms et les couches d'oxydes créés, par exemple en oxydes d'arseniure de gallium de l'ordre de 300 Angströms.

L'invention n'est pas limitée aux exemples d'applications explicitement décrits mais s'applique toutes les fois que l'on désire réduire une couche de composé ou plusieurs couches disposées sur un substrat sous-jacent. Elle est toutefois particulièrement avantageuse lorsque l'une au moins des caractéristiques suivantes est mise en jeu :

a) le substrat est instable à la température de traitement, l'électrolyte solide agissant alors comme conducteur ionique et comme encapsulant évitant alors la décomposition du substrat.

b) le substrat est monocristallin ; les espèces réduites peuvent se réorganiser de manière épitaxique sur le substrat.

c) le substrat est réactif à l'air libre et s'oxyde spontanément ; l'électrolyte agit alors comme passivant de la surface réduite.

## REVENDICATIONS

1. Procédé de réduction d'au moins une couche (2) de composé oxydé par une espèce déterminée recouvrant tout ou partie de la surface d'un substrat (1) ; caractérisé en ce qu'il comprend :

- une première étape pendant laquelle une couche (3) d'un électrolyte solide conducteur électronique et conducteur ionique de ladite espèce déterminée est disposée de manière à recouvrir uniformément la surface du substrat ;

- et une seconde étape pendant laquelle ladite réduction est effectuée au travers de la couche (3) d'électrolyte solide.

2. Procédé selon la revendication 1 caractérisé en ce que pendant la première étape le matériau constituant l'électrolyte solide est déposé uniformément sur la surface du substrat par pulvérisation cathodique de manière à créer ladite couche (3) d'électrolyte solide.

3. Procédé selon la revendication 1, caractérisé en ce que la seconde étape comprend l'exposition du substrat (1), recouvert d'au moins une couche (2) de composé oxydé, au travers de ladite couche (3) d'électrolyte solide à une atmosphère réductrice composée d'un mélange gazeux comprenant au moins ladite espèce déterminée et vérifiant simultanément les relations suivantes :

$P_R > P_{esp} > P_O$ ;
$T_R > T > T_O$ ;
$T_D > T$ ;

dans lesquelles :

. $P_R$ et $T_R$ sont respectivement la pression partielle maximale de l'espèce déterminée et la température maximale pour laquelle il y a réduction de chaque composé oxydé ;

. $P_{esp}$ et $T$ sont respectivement la pression partielle de l'espèce déterminée dans ledit mélange gazeux et la température de ce mélange ;

. $P_O$ et $T_O$ sont respectivement la pression partielle minimale de l'espèce déterminée et la température minimale pour laquelle il y a oxydation de la couche d'électrolyte ;

. et $T_D$ est la température la plus basse de destruction d'au moins un

composé oxydé.

4. Procédé selon la revendication 1, caractérisé en ce que la seconde étape comprend l'exposition du substrat (1), recouvert d'au moins une couche (2) de composé oxydé, au travers de ladite couche (3) d'électrolyte solide à un plasma réducteur.

5. Procédé selon la revendication 4, caractérisé en ce que le plasma réducteur est un plasma d'hydrogène radio-fréquence.

6. Procédé selon l'une quelconque des revendications 1 à 5, caractérisé en ce que ladite espèce déterminée est l'oxygène.

7. Procédé selon la revendication 6, caractérisé en ce que le substrat (1) est en arseniure de gallium et en ce que le composé à réduire comprend des oxydes de gallium et d'arsenic.

8. Procédé selon la revendication 7, caractérisé en ce que le mélange gazeux est porté à une température de 500°C et comprend de l'hydrogène et de la vapeur d'eau en proportion égale à 0.5 p.p.m. de manière à créer une pression partielle d'oxygène égale à $10^{-35}$ Pa.

9. Procédé selon la revendication 6, caractérisé en ce que la couche (3) d'électrolyte solide est en zircone stabilisée à la chaux dans des proportions atomiques respectives de 85% et de 15% et en ce que l'épaisseur de la couche est comprise dans la gamme 1000 Angströms à 2500 Angströms.

10. procédé selon la revendications 6, caractérisé en ce que le composé à réduire est un composé d'un matériau différent du matériau consituant ledit substrat.

11. procédé selon la revendication 6, caractérisé en ce que le substrat est en arseniure de gallium et en ce que le composé à réduire comprend une première couche (2) d'oxydes de gallium et d'arsenic et une seconde couche (6), superficielle, d'oxydes d'un matériau distinct de celui du substrat.

12. Procédé selon la revendication 11, caractérisé en ce que la seconde couche (6), superficielle, est constituée d'oxydes d'antimoniure de gallium.

13. Procédé selon la revendication 6, caractérisé en ce que le composé à réduire comprend un oxyde métallique (2').

14. Procédé selon la revendication 13, caractérisé en ce que l'oxyde métallique (2') recouvre uniformément la surface du substrat.

15. Procédé selon la revendication 13, caractérisé en ce que l'oxyde

métallique est constitué d'un réseau (2') d'interconnexion recouvrant des régions déterminées de la surface du substrat.

16. Procédé selon l'une quelconque des revendications 1 à 5, caractérisé en ce que ladite espèce déterminée est de l'azote.

17. Procédé selon la revendication 16, caractérisé en ce que le composé à réduire est du nitrure de silicium et l'électrolyte solide est l'alumine β amonium.

18. Procédé de fabrication d'une structure semiconductrice à effet de champ du type "M.I.S." comprenant les étapes du procédé de réduction selon l'une quelconque des revendications 1 à 17 caractérisé en ce qu'il comprend une étape supplémentaire exécutée à la suite de la seconde étape du procédé de réduction consistant au dépôt d'une plage métallique (5) recouvrant des régions déterminées de la surface de la couche (3) d'électrolyte solide de manière à former un empilement d'au moins une couche de semiconducteur réduit (1'), une couche de diélectrique formé par la couche (3) d'électrolyte solide et une couche métallique (5) ; empilement constituant la structure "M.I.S.".

FIG.1

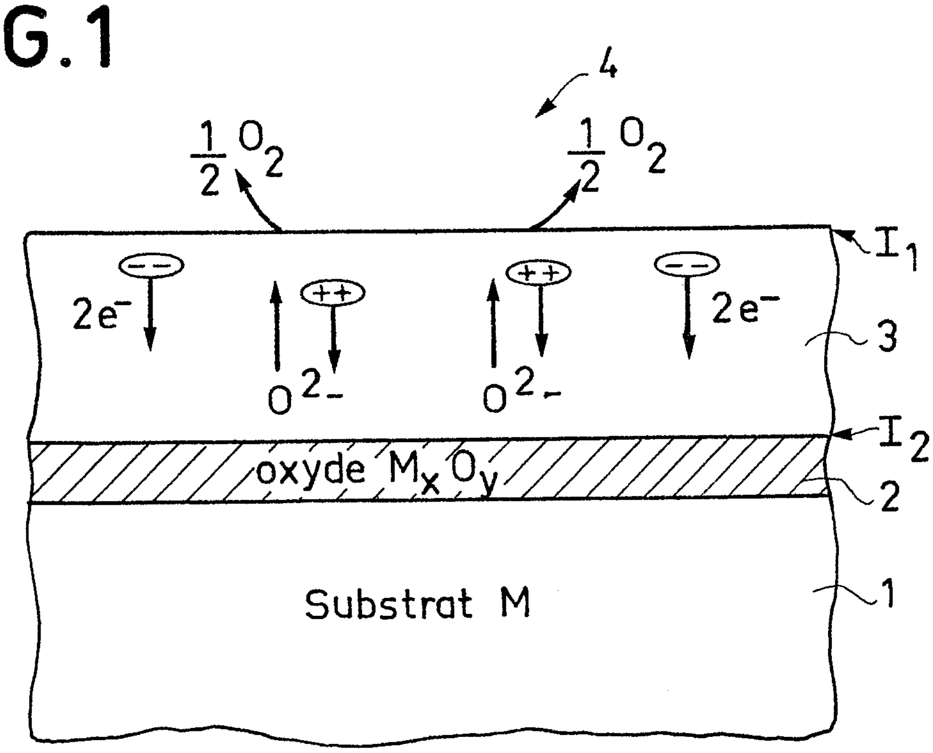
4
1/2 O2
1/2 O2
I1
2e⁻
O2-
O2-
2e⁻
3
I2
oxyde MxOy
2
Substrat M
1

FIG. 6

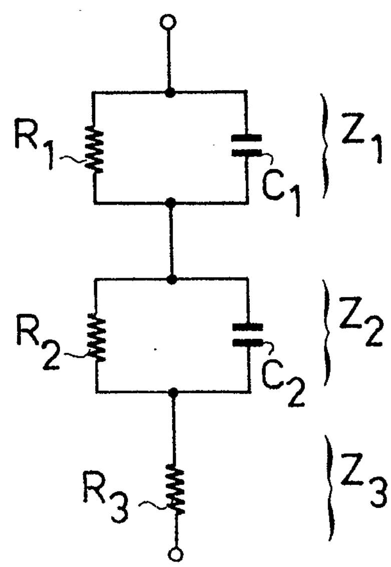
R1
C1
Z1
R2
C2
Z2
R3
Z3

FIG.7

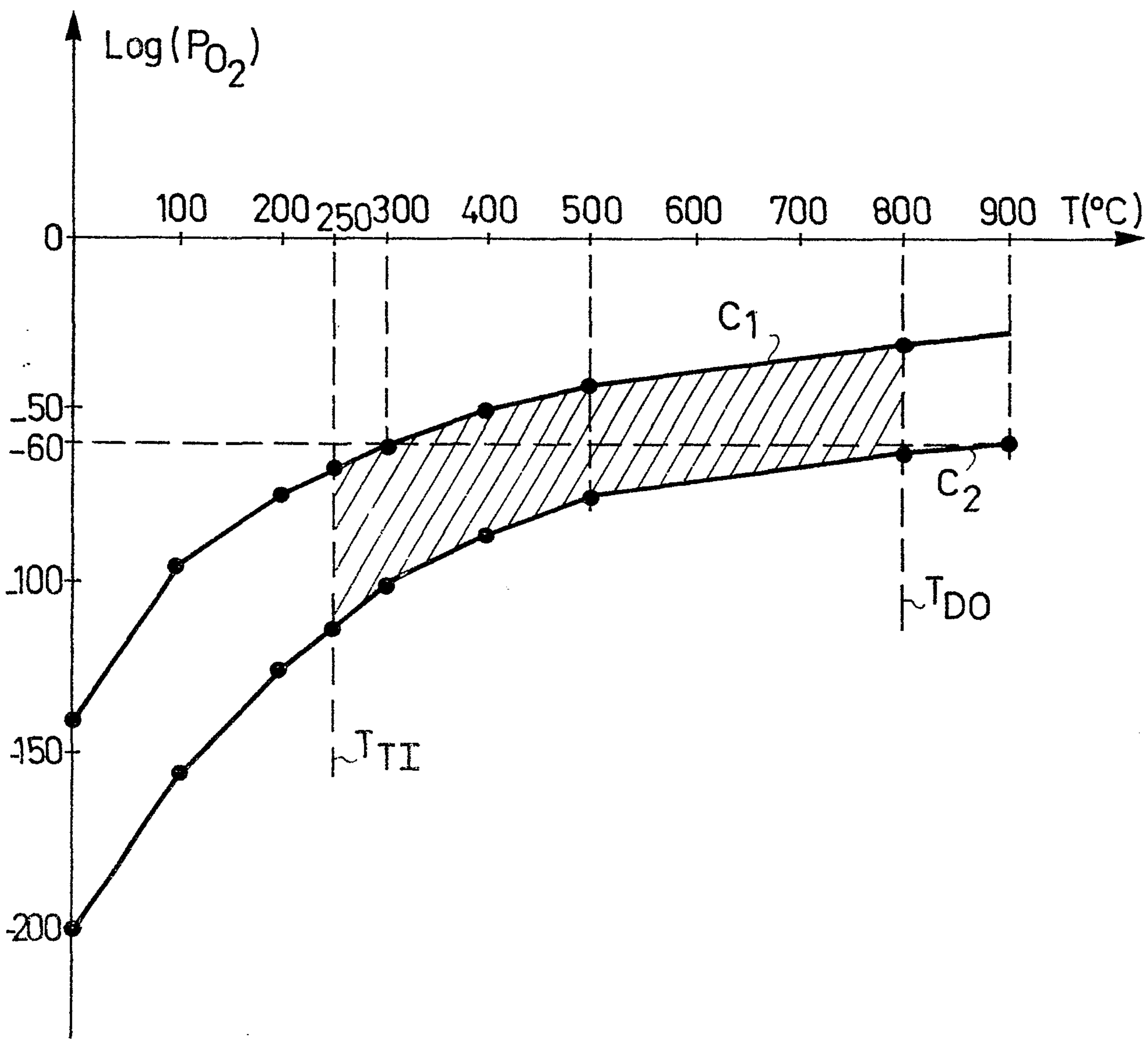
Log ($P_{O_2}$)
100
200
250
300
400
500
600
700
800
900
T(°C)
0
-50
-60
-100
-150
-200
$C_1$
$C_2$
$T_{DO}$
$T_{TI}$

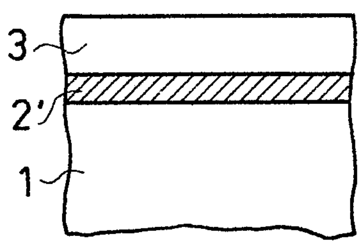


FIG.8

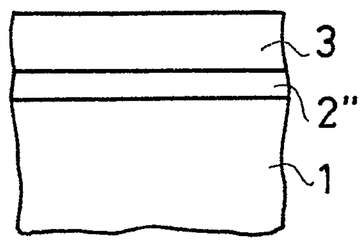


FIG.9

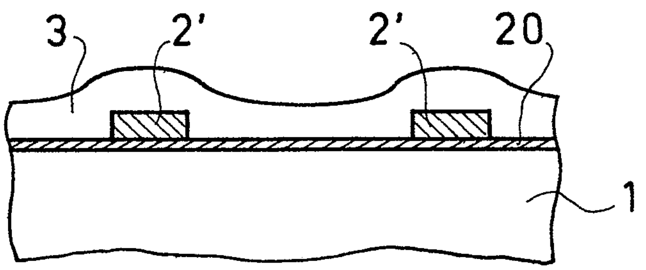


FIG.10

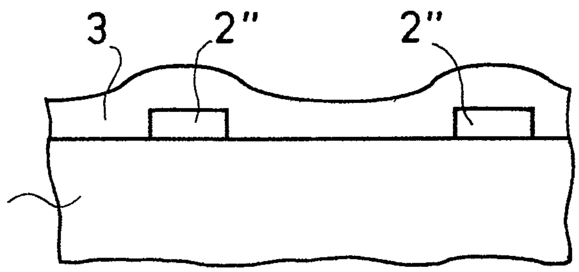


FIG.11

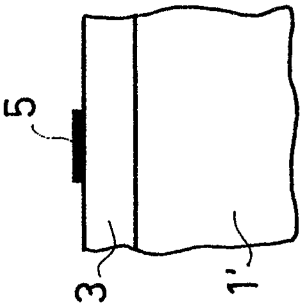


FIG.5

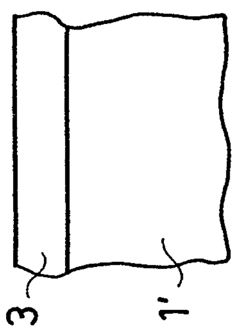


FIG.4

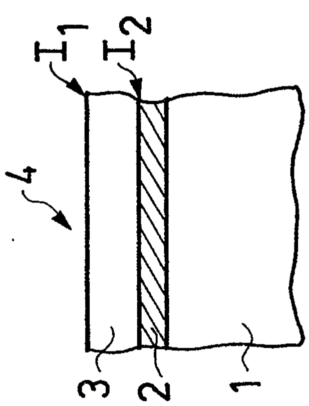


FIG.3

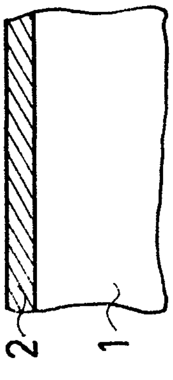


FIG.2

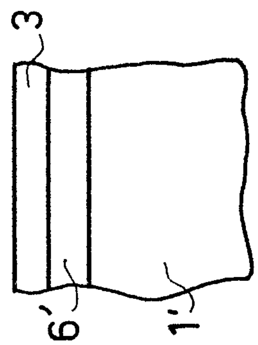


FIG.15

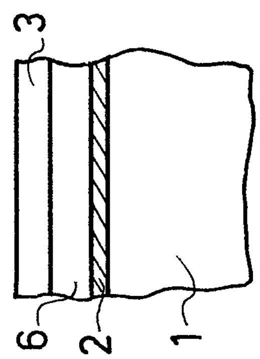


FIG.14

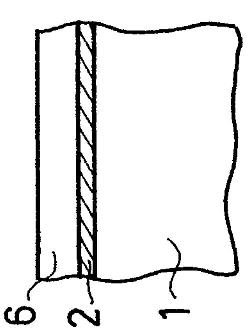


FIG.13

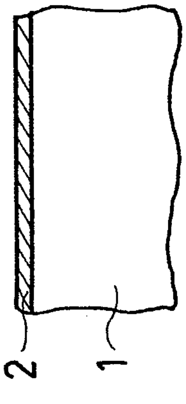


FIG.12

0100251

Office européen des brevets

# RAPPORT DE RECHERCHE EUROPEENNE

Numéro de la demande

EP 83 40 1260

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. 3) |
|---|---|---|---|
| X,Y | FR-A-1 513 897 (S.A. BBC)<br>* page 2, colonne 1, paragraphe 7 - page 3, colonne 1, paragraphe 1; résumé * | 1,3,4, 6,9,10 ,13,14 | H 01 L 21/31<br>H 01 L 21/316<br>H 01 L 21/302<br>H 01 L 29/62 //<br>H 01 M 8/12 |
| Y | US-A-3 532 627 (GENERAL ELECTRIC CY.)<br>* en entier * | 1,3,4, 6,9,10 ,13,14 | |
| Y | US-A-3 522 103 (GENERAL ELECTRIC CY.)<br>* en entier * | 1,3,4, 6,9,10 ,13,14 | |
| A | APPLIED PHYSICS LETTERS, vol. 38, no. 11, 1 juin 1981, pages 898-899, American Institute of Physics, New York, USA R.P.H. CHANG et al.: "Hydrogen plasma etching of GaAs oxide" * page 898, résumé * | 5,7 | DOMAINES TECHNIQUES RECHERCHES (Int. Cl. 3)<br>H 01 L<br>H 01 M |
| A | US-A-3 943 014 (SANKEN ELECTRIC CY.)<br>* colonne 1, paragraphes 1-3 *<br>--- -/- | 1 | |

Le présent rapport de recherche a été établi pour toutes les revendications

| Lieu de la recherche | Date d'achèvement de la recherche | Examinateur |
|---|---|---|
| LA HAYE | 11-10-1983 | VANCRAEYNEST F.H. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire
T : théorie ou principe à la base de l'invention
E : document de brevet antérieur, mais publié à la date de dépôt ou après cette date
D : cité dans la demande
L : cité pour d'autres raisons

& : membre de la même famille, document correspondant

0100251

Office européen des brevets

# RAPPORT DE RECHERCHE EUROPEENNE

Numero de la demande

EP 83 40 1260

Page 2

| DOCUMENTS CONSIDERES COMME PERTINENTS | | | |
|---|---|---|---|
| Catégorie | Citation du document avec indication, en cas de besoin, des parties pertinentes | Revendication concernée | CLASSEMENT DE LA DEMANDE (Int. Cl. 3) |
| P,X | THIN SOLID FILMS, vol. 130, no. 1/2, mai 1983, pages 221-242, Elsevier Sequoia, NL. M. CROSET et al.: "Calcia-stabilized zirconia thin films in GaAs metal/insulator/semiconductor technology: reduction of GaAs native oxide" * en entier * ----- | 1-18 | |
| | | | DOMAINES TECHNIQUES RECHERCHES (Int. Cl. 3) |

Le présent rapport de recherche a été établi pour toutes les revendications

| Lieu de la recherche | Date d'achèvement de la recherche | Examinateur |
|---|---|---|
| LA HAYE | 11-10-1983 | VANCRAEYNEST F.H. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03.82